# EUROPEAN PATENT APPLICATION

(11) **EP 2 383 781 A1**
(43) Date of publication of application: **02.11.2011**
(21) Application number: 10160335.5
(22) Date of filing: 19.04.2010
(51) Int. Cl.: H01L 27/08, H01L 29/94

(54) **MOS capacitor structure with linear capacitance-voltage curve**

(71) Applicant: Dialog Semiconductor B.V., 5215 MV 's-Hertogenbosch (NL)
(72) Inventor: Kruiskamp, Marinus Wilhelmus, 5237 CB ', 's-Hertogenbosch (NL); Hoogstraate, Anthonie Jacobus, 5629 PE, Eindhoven (NL); Vidojkovic, Vojkan, 5583 EA, Waalre (NL)
(74) Representative: Ketelaars, Maarten F.J.M.

(57) **Abstract**

A MOS capacitor structure having:
• a first series connection of a first offset-voltage source and a first MOS capacitor, the first offset-voltage source providing a first offset voltage to the first MOS capacitor;
• a second series connection of a second offset-voltage source and a second MOS capacitor, the second offset-voltage source providing a second offset voltage to the second MOS capacitor.

The first and second series connections are connected in parallel such that the first and second MOS capacitors are arranged in an anti-parallel way.

## Description

### Field of the invention

The field of the invention is related to linearizing the capacitance to voltage dependency of a MOS capacitor structure.

### Background of the invention

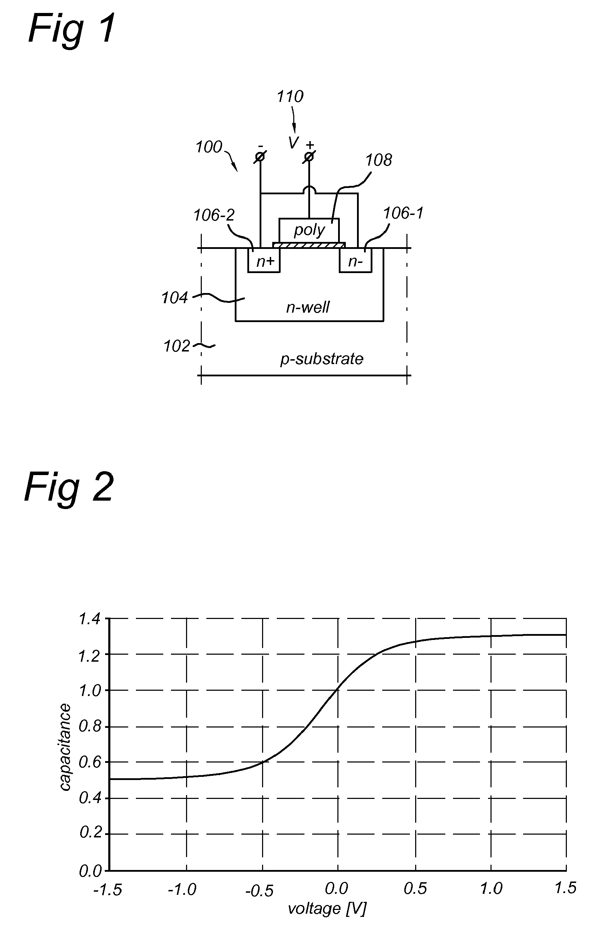

In standard complementary metal-oxide-semiconductor (CMOS) technology, the density of metal-oxide-semiconductor (MOS) capacitors is much higher than linear capacitors. Figure 1 shows, as example, a cross-section of a MOS capacitor structure. A MOS capacitor 100 comprises an N type well region 104 formed in a P type substrate 102 biased to a low reference voltage such as ground. Inside the N type well 104, an N-contact region 106-1 is formed to provide a biasing for the N type well region 104, as well as another N+ contact region 106-2. The N type well region 104 is actually the negative terminal of the MOS capacitor structure. The N- contact region 106-1 and N+ contact region 106-2 make it possible to connect the capacitor structure to the rest of the circuit in which the capacitor structure is used. A poly-silicon portion 108 is provided which is often called the gate of the capacitor structure, and is in fact the positive terminal of the MOS capacitor structure. The other terminal provided by both N- contact region 106-1 and N+ contact region 106-2 is often called "bottom-plate of the capacitor" or negative terminal.

Figure 2 shows a Capacitance-Voltage curve of a MOS capacitor. In the voltage range of [-0.5V, 0.5V], the capacitance value of the MOS capacitor increases nonlinearly from 0.5pf to 1.25pf. It indicates that the capacitance of MOS capacitors is nonlinearly voltage dependent which make them less suitable for signal processing circuits (e.g. filters).

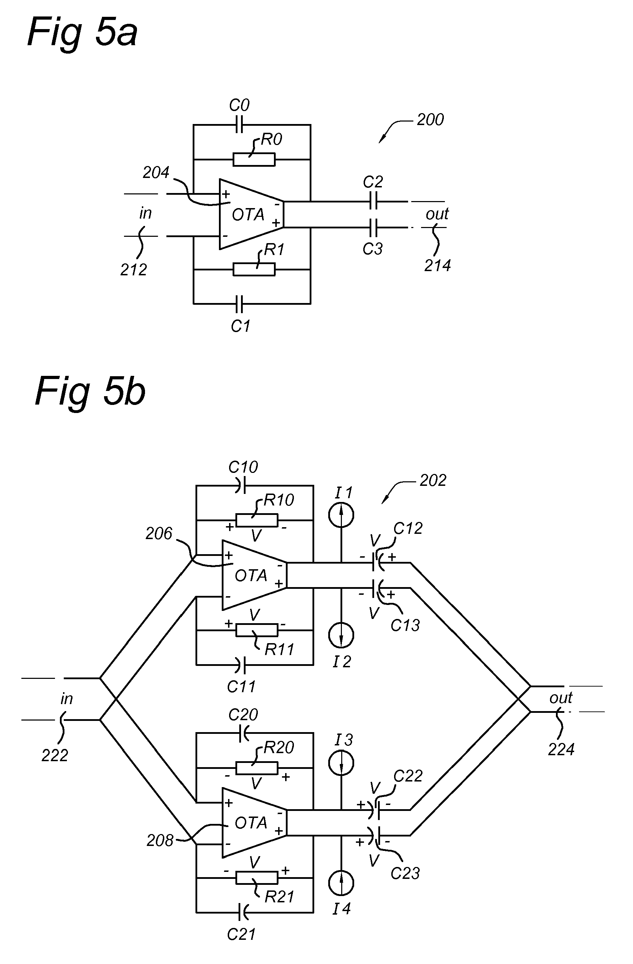

Some prior art circuit arrangements depicted in figure 5a, 6a, and 7a, respectively, are commonly used in filters and signal processing devices. Such circuits comprise one or more capacitors that should show a linear capacitance-voltage characteristic.

In figure 5a, a circuit arrangement 200 comprises: an operational transconductance amplifier (OTA) 204 for creating a virtual ground at the input terminal 212.. The OTA 204 has a positive input and a negative input, as well as a positive output and a negative output. A resistor R0 and a capacitor C0 are connected in parallel to the upper part of OTA 204, with one end connected to the positive input of the OTA 204 and with the other end connected to the negative output of the OTA 204. A resistor R1 and a capacitor C1 are connected in parallel to the lower part of the OTA 204, with one end connected to the negative input of the OTA 204 and with the other end connected to the positive output of the OTA 204. A capacitor C2 is connected to the negative output of the OTA 204. A capacitor C3 is connected to the positive output of the OTA 204. Capacitors C2 and C3 are couple capacitors. In an embodiment, the resistors R0 and R1 have the same resistance value. The capacitors C0 and C1 may have the same capacitance value. The capacitors C2 and C3 may have the same capacitance value. In the arrangement of figure 5a, at least the capacitors C0 and C1 should have a capacitance-voltage characteristic that is preferably as linear as possible. However, the same may be true for capacitors C2 and C3.

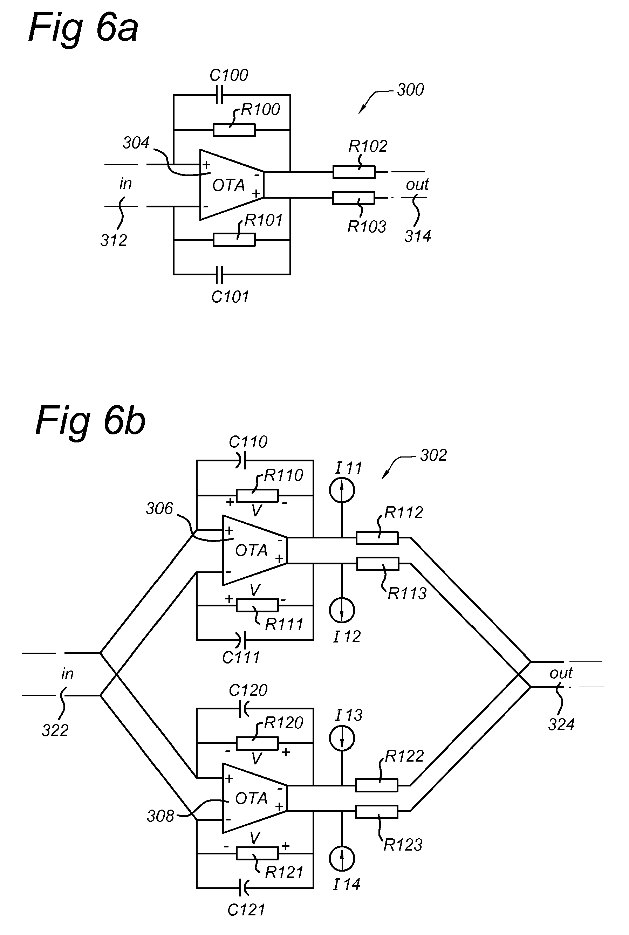

In figure 6a, a circuit arrangement 300 comprises: an operational transconductance amplifier (OTA) 304 for creating a virtual ground at the input 312. The OTA 304 has a positive input and a negative input, as well as a positive output and a negative output. A resistor R100 and a capacitor C100 are connected in parallel to the upper part of OTA 304, with one end connected to the positive input of the OTA 304 and with the other end connected to the negative output of the OTA 304. A resistor R101 and a capacitor C101 are connected in parallel to the lower part of the OTA 304, with one end connected to the negative input of the OTA 304 and with the other end connected to the positive output of the OTA 304. A resistor R102 is connected to the negative output of the OTA 304. A resistor R103 is connected to the positive output of the OTA 204. In an embodiment, the resistors R100 and R101 may have the same resistance value. The capacitors C100 and C101 may have the same capacitance value The resistors R102 and R103 may have the same resistance value. In the arrangement of figure 6a, at least the capacitors C100 and C101 should have a capacitance-voltage characteristic that is preferably as linear as possible.

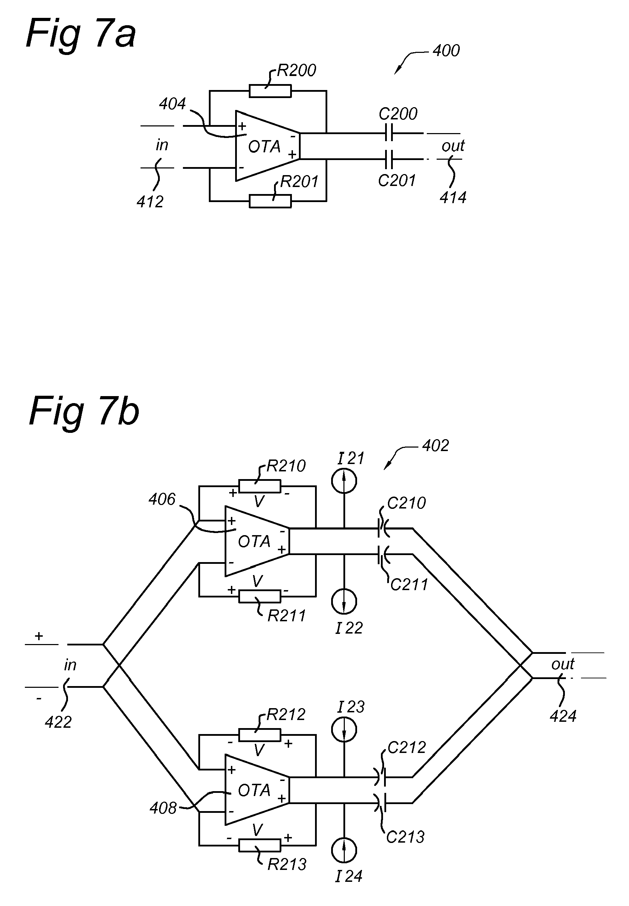

In figure 7a, a circuit arrangement 400 comprises: an operational transconductance amplifier (OTA) 404 for creating a virtual ground at the input 412. The OTA 404 has a positive input and a negative input, as well as a positive output and a negative output. A resistor R200 is connected to the upper part of OTA 404, with one end connected to the positive input of the OTA 404 and with the other end connected to the negative output of the OTA 404. A resistor R201 is connected to the lower part of the OTA 404, with one end connected to the negative input of the OTA 404 and with the other end connected to the positive output of the OTA 404. A capacitor C200 is connected to the negative output of the OTA 404. A capacitor C201 is connected to the positive output of the OTA 404. In an embodiment, the resistors R200 and R201 may have the same resistance value. The capacitors C200 and C201 may have the same capacitance value. In the arrangement of figure 7a, at least the capacitors C200 and C201 should have a capacitance-voltage characteristic that is preferably as linear as possible.

There are several known ways to linearize the CV-curve of a MOS capacitor.

### 1. Serial compensation

In serial compensation, the desired capacitor structure is made by two MOS capacitors connected in series with usually the gates of the two MOS capacitors connected to each other and the gates biased at a high voltage compared to the n-well.

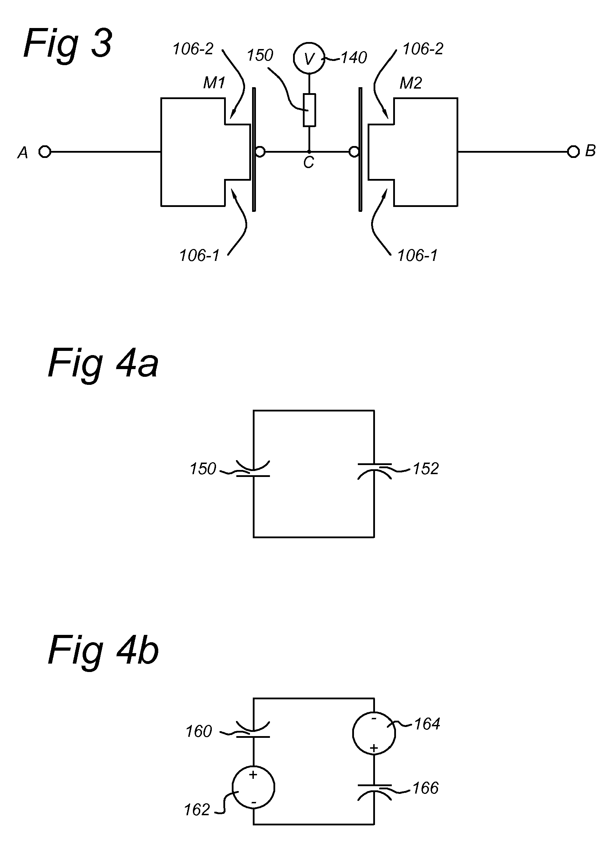

Figure 3 shows an example of a serial compensation capacitor structure. The gate of a capacitor M1 is connected to the gate of a capacitor M2. Both the gate of the capacitor M1 and the gate of the capacitor M2, with the same functionality as the poly-silicon portion 108 depicted in Fig. 1, are connected to a power supply 140 via a high-ohmic resistor 150. The drain and the source of capacitor M1, with same functionality as the N-contact region 106-1 and N+ contact region 106-2 depicted in Fig. 1, respectively, and of capacitor M2 are connected together. The junction of drain and source of capacitor M1 may be connected directly to an input terminal A. The drain and the source of capacitor M2 are connected together via a junction. That junction, as shown ,may be connected directly to an input terminal B.The two MOS capacitors in the capacitor structure are now both used in a region where the capacitance is almost independent of the voltage, i.e., preferably in the range where the supply voltage is >0.5V. Then, an additional advantage is that the capacitance of the MOS capacitor is at its maximum. The disadvantage is that the area of this desired capacitor structure is about three times greater than the area of a single unbiased MOS capacitor: since the two capacitors are in series, the capacitance value of each capacitor has to be double the capacitance value of the desired capacitor. The fact that the capacitance of the desired capacitor structure is at its maximum for a positive bias voltage compensates a little for this, resulting in about a factor three of area increase. More examples of this technique can be found in prior art references [1] and [2].

### 2. Parallel compensation

In parallel compensation, the desired capacitor structure is made by two MOS capacitors connected anti-parallel. Figure 4a shows an example of an anti-parallel compensation capacitor structure. The positive terminal of a capacitor 150 is connected to the negattive terminal of a capacitor 152. The negative terminal of the capacitor 150 is connected to the positive terminal of the capacitor 152.

The C-V curve of the anti-parallel connection is much more linear than the C-V curve of the single MOS capacitor, without the penalty of increased area. However, there is still a 10% capacitance variation over voltage: at about 0 V, the capacitance is about 1.1 times higher than at lower or higher voltages.

### 3. Compensation by connecting many capacitors in a complex structure

By providing a capacitance structure with multiple capacitors connected in a rather complex way, it is possible to make the C-V curve much more linear than with parallel compensation. However, then the required area is much larger than the area required for parallel compensation, since there are a lot of capacitors in series. Examples of this technique can be found in prior art reference [3].

### Summary of the invention

The object of the invention is to provide a MOS capacitor structure with a configuration that shows a good overall linear Capacitance-Voltage characteristic with a limited area penalty.

This object is obtained by a method as claimed in claim 1 and a MOS capacitor structure as claimed in claim 4.

### Brief description of the drawings

The invention will be explained in detail with reference to some drawings that are only intended to show embodiments of the invention and not to limit the scope. The scope of the invention is defined in the annexed claims and by its technical equivalents.
The drawings show:
Figure 1 shows an example of a cross-section of a MOS capacitor.
Figure 2 shows a Capacitance-Voltage curve of a MOS capacitor.
Figure 3 shows an example of a serial compensation capacitor structure.
Figure 4a shows an example of a parallel compensation capacitor structure.
Figure 4b shows an embodiment of a circuit arrangement according to the invention.
Figure 5a shows an example of a prior art circuit arrangement.
Figure 5b shows an embodiment of a circuit arrangement according to the invention.
Figure 6a shows an example of a prior art circuit arrangement.
Figure 6b shows an embodiment of a circuit arrangement according to the invention.
Figure 7a shows an example of a prior art circuit arrangement.
Figure 7b shows an embodiment of a circuit arrangement according to the invention.
Figure 8 shows a Capacitance-Voltage curve of a capacitor structure according to the invention with a certain constant offset voltage compared to a prior art MOS capacitor.

### Detailed description of embodiments

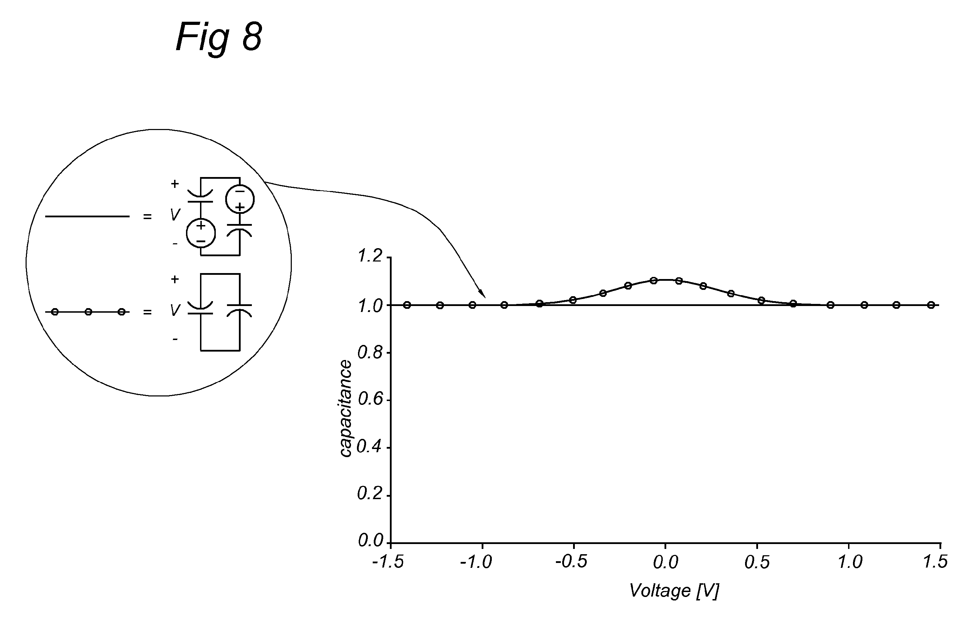

The dotted curve on top of figure 8 shows the C-V curve of an anti-parallel compensation capacitor structure depicted in figure 4a. The anti-parallel compensation capacitor structure is constructed by placing two corresponding MOS capacitor structures anti-parallel. In the anti-parallel compensation capacitor structure depicted both in figure 4a and on top of the ellipse in figure 8, the positive terminal of a first capacitor is connected to the negative terminal of a second capacitor. The negative terminal of the first capacitor is connected to the positive terminal of the second capacitor. The solid line curve in figure 8 shows the C-V curve of an anti-parallel compensation capacitor structure in accordance with the invention and as depicted in figure 4b, with offset voltage sources connected in series with both capacitors, respectively. In the anti-parallel compensation capacitor structure depicted both in figure 4b and on the top of the ellipse in figure 8, the negative terminal of a first capacitor 160 is connected to the positive portion of a first offset voltage source 162, the positive terminal of the first capacitor 160 is connected to the negative portion of a second offset voltage source 164, the positive terminal of a second capacitor is connected to the negative portion of the first offset voltage source 162, and the negative terminal of the second capacitor 166 is connected to the positive portion of the second offset voltage source 164. The voltages provided by the first and second offset voltage sources 162, 164 are constant voltages. The C-V curve associated with this circuit setup is shown as a solid line in the upper part of figure 8: it is a flat linear curve where the capacitance value is constant and independent from the voltage. So, this circuit would be ideal. However, in practice, this anti-parallel compensation capacitor structure is difficult to be made.

In conclusion, the MOS capacitor with an anti-parallel compensation capacitor structure with a certain constant offset voltage, as shown on top of the ellipse in figure 8, shows a substantially linear C-V curve, without the penalty of increased area. Such a C-V curve will be obtained when the voltage sources are "ideal" voltage sources. Such "ideal" voltage sources are not available as real components but circuits can be designed that approach the behavior of an "ideal" voltage source.

In embodiments of the invention, as explained hereinafter, the ideal circuit is "simulated", i.e. the offset voltage sources are implemented by offset current sources and circuit components that cause a slight off-set voltage.

The present specification provides three embodiments as shown in figure 5b, 6b, and 7b, respectively, which are designed to provide the functionality of prior art circuits depicted in figure 5a, 6a, and 7a, respectively, however, where the respective circuits have been implemented by MOS capacitor structures with substantially linear voltage characteristic.

In Figure 5b, a circuit arrangement 202 comprises the following components.

The circuit arrangement has a positive and negative input terminal to which an input current 222 can be provided. The positive input terminal is connected to both the positive input of an operational transconductance amplifier (OTA) 206 and the positive input of an OTA 208. The negative input terminal is connected to both the negative input of the OTA 206 and the negative input of the OTA 208.

A resistor R10 and a capacitor C10 are connected in parallel to the upper part of OTA 206, with one end connected to the positive input of the OTA 206 and with the other end connected to the negative output of the OTA 206. The end of the capacitor C10 connected to the positive input of OTA 206 is its positive terminal, whereas the end of capacitor C10 connected to the negative output of OTA 206 is its negative terminal. A resistor R11 and a capacitor C11 are connected in parallel to the lower part of the OTA 206, with one end connected to the negative input of the OTA 206 and with the other end connected to the positive output of the OTA 206. The end of the capacitor C11 connected to the negative input of OTA 206 is its negative terminal, whereas the end of capacitor C11 connected to the positive output of OTA 206 is its positive terminal. A capacitor C12 has a negative terminal connected to the negative output of the OTA 206. A capacitor C13 has a negative terminal connected to the positive output of the OTA 206. In an embodiment, the resistors R10 and R11 have the same resistance value. The capacitors C10 and C11 may have the same capacitance value. The capacitors C12 and C13 may have the same capacitance value.

A resistor R20 and a capacitor C20 are connected in parallel to the upper part of OTA 208, with one end connected to the positive input of the OTA 208 and with the other end connected to the negative output of the OTA 208. The end of the capacitor C20 connected to the positive input of OTA 208 is its negative terminal, whereas the end of capacitor C20 connected to the negative output of OTA 208 is its positive terminal. A resistor R21 and a capacitor C21 are connected in parallel to the lower part of the OTA 208, with one end connected to the negative input of the OTA 208 and with the other end connected to the positive output of the OTA 208. The end of the capacitor C21 connected to the negative input of OTA 208 is its negative terminal, whereas the end of capacitor C21 connected to the positive output of OTA 208 is its positive terminal. A capacitor C22 has an positive terminal connected to the negative output of the OTA 208. A capacitor C23 has an positive terminal connected to the positive output of the OTA 208. In an embodiment, the resistors R20 and R21 have the same resistance value. The capacitors C20 and C21 may have the same capacitance value. The capacitors C22 and C23 may have the same capacitance value.

A positive output terminal is connected to both the positive terminal of capacitor C12 and the negative terminal of capacitor C22. A negative output terminal is connected to both the positive terminal of capacitor C13 and the negative terminal of capacitor C23. The positive and negative output terminals provide an output voltage 224.

An offset-current source I1 is connected to both the negative output of the OTA 206, the negative terminal of capacitor C10 and the negative terminal of the capacitor C12. An offset-current source I2 is connected to both the positive output of the OTA 206, the negative terminal of capacitor C11 and the negative terminal of the capacitor C13. An offset-current source I3 is connected to both the negative output of the OTA 208, the positive terminal of the capacitor C20 and the positive terminal of the capacitor C22. An offset-current source I4 is connected to both the positive output of the OTA 208, the positive terminal of the capacitor C21 and the positive terminal of the capacitor C23.

The offset-current source I1 provides an offset-current to both the negative output of the OTA 206, the negative terminal of capacitor C10 and the negative terminal of the capacitor C12. The offset-current source I2 provides an offset-current to both the positive output of the OTA 206, the negative terminal of the capacitor C11 and the negative terminal of the capacitor C13.

The offset-current source I3 provides an offset-current to both the negative output of the OTA 208, the positive terminal of the capacitor C20 and the positive terminal of the capacitor C22. The offset-current source I4 provides an offset-current to both the positive output of the OTA 208, the positive terminal of the capacitor C21 and the positive terminal of the capacitor C23.

Together with the feedback loops of R10/C10 and R11/C11, respectively, of OTA 206 the off-set current sources I1 and I2, respectively, provide a proper DC offset voltage of about 0.5V (or more) for capacitors C10 and C11, respectively. Together with the feedback loops of R20/C20 and R21/C21, respectively, of OTA 208 the off-set current sources I3 and I4 provide a proper DC offset voltage of about 0.5V (or more) for capacitors C20 and C21, respectively.

In the arrangement of figure 5b, the capacitors C10 en C20 are arranged in an anti-parallel circuit, where current sources I1 and I3 cause an offset voltage in order to produce a semi-ideal MOS capacitor circuit, like the one shown on top of the ellipse in figure 8. So, the circuit elements comprising capacitor C10, resistor R10, and current source I1 arranged in parallel to the circuit elements comprising capacitor C20, resistor R20, and current source 13 together form an implementation of the capacitor C10 of figure 5a, with linear capacitance-voltage characteristic.

In a similar way, the capacitors C11 en C21 are arranged in an anti-parallel circuit, where current sources I2 and I4 cause an offset voltage in order to produce a semi-ideal MOS capacitor circuit, like the one shown on top of the ellipse in figure 8. So, the circuit elements comprising capacitor C11, resistor R11, and current source 12 arranged in parallel to the circuit elements comprising capacitor C21, resistor R21, and current source 14 together form an implementation of the capacitor C1 of figure 5a, with linear capacitance-voltage characteristic.

It is observed that resistor R10 and current source I1 also provide an offset voltage to capacitor C12. Moreover, in a similar way resistor R11 and current source 12 also provide an offset voltage to capacitor C13, resistor R20 and current source 13 also provide an offset voltage to capacitor C22, and resistor R21 and current source 14 also provide an offset voltage to capacitor C23.

So, the circuit elements comprising capacitor C12, resistor R10, and current source I1 arranged in parallel to the circuit elements comprising capacitor C22, resistor R20, and current source I3 together form an implementation of the capacitor C2 of figure 5a, with linear capacitance-voltage characteristic.

Similarly, the circuit elements comprising capacitor C13, resistor R11, and current source 12 arranged in parallel to the circuit elements comprising capacitor C23, resistor R21, and current source I4 together form an implementation of the capacitor C3 of figure 5a, with linear capacitance-voltage characteristic.

All resistors R10, R11, R20, R21 may have the same resistance value. Moreover, all capacitors C10, C11, C20 and C21 may have the same capacitance value. Also all capacitors C12, C13, C22 and C23 may have the same capacitance value. Preferably, offset-current source I1 provides substantially the same offset-current as offset-current source I4. Preferably, offset-current source I2 provides substantially the same offset-current as offset-current source I3. The offset-current provided by I1 added to the offset-current provided by I3 may be equal to zero. The offset-current provided by I2 added to the offset-current provided by I4 may be equal to zero.

OTA 206 is, preferably, arranged in the same way as OTA 208.

In Figure 6b, a circuit arrangement 302 comprises the following components.

The circuit arrangement has a positive and negative input terminal to which an input current 322 can be provided. The positive input terminal is connected to both the positive input of an operational transconductance amplifier (OTA) 306 and the positive input of an OTA 308. The negative input terminal is connected to both the negative input of the OTA 306 and the negative input of the OTA 308.

A resistor R110 and a capacitor C110 are connected in parallel to the upper part of OTA 306, with one end connected to the positive input of the OTA 306 and with the other end connected to the negative output of the OTA 306. The end of the capacitor C110 connected to the positive input of OTA 306 is its positive terminal, whereas the end of capacitor C110 connected to the negative output of OTA 306 is its negative terminal. A resistor R111 and a capacitor C111 are connected in parallel to the lower part of the OTA 306, with one end connected to the negative input of the OTA 306 and with the other end connected to the positive output of the OTA 306. The end of the capacitor C110 connected to the positive input of OTA 306 is its positive terminal, whereas the end of capacitor C110 connected to the negative output of OTA 306 is its negative terminal. A resistor R112 has one end connected to the negative output of the OTA 306. A resistor R113 has one end connected to the positive output of the OTA 306. In an embodiment, the resistors R110 and R111 may have the same resistance value. The capacitors C110 and C111 may have the same capacitance value. The resistors R112 and R113 may have the same resistance value.

A resistor R120 and a capacitor C120 are connected in parallel to the upper part of OTA 308, with one end connected to the positive input of the OTA 308 and with the other end connected to the negative output of the OTA 308. The end of the capacitor C120 connected to the positive input of OTA 308 is its negative terminal, whereas the end of capacitor C120 connected to the negative output of OTA 308 is its positive terminal. A resistor R121 and a capacitor C121 are connected in parallel to the lower part of the OTA 308, with one end connected to the negative input of the OTA 308 and with the other end connected to the positive output of the OTA 308. The end of the capacitor C121 connected to the negative input of OTA 308 is its negative terminal, whereas the end of capacitor C121 connected to the positive output of OTA 308 is its positive terminal. A resistor R122 has one end connected to the negative output of the OTA 308. A resistor R123 has one end connected to the positive output of the OTA 308. In an embodiment, the resistors R120 and R121 have the same resistance value. The capacitors C120 and C121 may have the same capacitance value. The resistors R122 and R123 may have the same capacitance value.

A positive output terminal is connected to both the other end of resistor R112 and the other end of resistor R122. A negative output terminal is connected to both the other end of resistor R113 and the other end of resistor R123. The positive and negative output terminals provide an output voltage 324.

An offset-current source I11 is connected to the negative output of the OTA 306 and the negative terminal of capacitor C110. An offset-current source I12 is connected to the positive output of the OTA 306 and the negative terminal of capacitor C111. An offset-current source I13 is connected to the negative output of the OTA 308 and the positive terminal of capacitor C120. An offset-current source I14 is connected to the positive output of the OTA 308 and the positive terminal of capacitor C121.

The offset-current source I11 provides an offset-current to the negative output of the OTA 306 and the negative terminal of capacitor C110. The offset-current source I12 provides an offset-current to the positive output of the OTA 306 and the negative terminal of capacitor C111.

The offset-current source I13 provides an offset-current to the negative output of the OTA 308 and the positive terminal of capacitor C120. The offset-current source I14 provides a positive offset-current to the positive output of the OTA 308 and the positive terminal of capacitor C121.

Together with the feedback loops of R110/C110 and R111/C111, respectively, of OTA 306 the off-set current sources In and I12 provide a proper DC offset voltage of about 0.5V (or more) for capacitors C110 and C111, respectively. Together with the feedback loops of R120/C120 and R121/C121, respectively, of OTA 308 the off-set current sources I13 and I14 provide a proper DC offset voltage of about 0.5V (or more) for capacitors C120 and C121, respectively.

In the arrangement of figure 6b, the capacitors C110 en C120 are arranged in an anti-parallel circuit, where current sources I11 and I13 cause an offset voltage in order to produce a semi-ideal MOS capacitor circuit, like the one shown on top of the ellipse in figure 8. So, the circuit elements comprising capacitor C110, resistor R110, and current source I11 arranged in parallel to the circuit elements comprising capacitor C120, resistor R120, and current source I13 together form an implementation of the capacitor C100 of figure 6a, with linear capacitance-voltage characteristic.

In a similar way, the capacitors C111 en C121 are arranged in an anti-parallel circuit, where current sources I12 and I14 cause an offset voltage in order to produce a semi-ideal MOS capacitor circuit, like the one shown on top of the ellipse in figure 8. So, the circuit elements comprising capacitor C111, resistor R111, and current source I12 arranged in parallel to the circuit elements comprising capacitor C121, resistor R121, and current source I14 together form an implementation of the capacitor C101 of figure 6a, with linear capacitance-voltage characteristic.

All resistors R110, R111, R120, R121 may have the same resistance value. Moreover, all capacitors C110, C111, C120 and C121 may have the same capacitance value. Also all capacitors C112, C113, C122 and C123 may have the same capacitance value. Preferably, offset-current source I11 provides substantially the same offset-current as offset-current source I14. Preferably, offset-current source I12 provides substantially the same offset-current as offset-current source I13. The offset-current provided by I11 added to the offset-current provided by I13 may be equal to zero. The offset-current provided by I12 added to the offset-current provided by I14 may be equal to zero.

OTA 306 is, preferably, arranged in the same way as OTA 308.

In Figure 7b, a circuit arrangement 402 comprises the following components.

A circuit arrangement 402 comprises an operational transconductance amplifier (OTA) 406. The OTA 406 has a positive input and a negative input, as well as a positive output and a negative output. A resistor R210 is connected to the upper part of OTA 406, with one end connected to the positive input of the OTA 406 and with the other end connected to the negative output of the OTA 406. A resistor R211 is connected to the lower part of the OTA 406, with one end connected to the negative input of the OTA 406 and with the other end connected to the positive output of the OTA 406. A capacitor C210 is, with its negative terminal, connected to the negative output of the OTA 406. A capacitor C211 is, with its negative terminal connected to the positive output of the OTA 406. In an embodiment, the resistors R210 and R211 may have the same resistance value. The capacitors C210 and C211 may have the same capacitance value.

The circuit arrangement 402 also comprises an operational transconductance amplifier (OTA) 408. The OTA 408 has a positive input and a negative input, as well as a positive output and a negative output. A resistor R212 is connected to the upper part of OTA 408, with one end connected to the positive input of the OTA 408 and with the other end connected to the negative output of the OTA 408. A resistor R213 is connected to the lower part of the OTA 408, with one end connected to the negative input of the OTA 408 and with the other end connected to the positive output of the OTA 408. A capacitor C212 is, with its positive terminal, connected to the negative output of the OTA 408. A capacitor C213 is, with its positive terminal connected to the positive output of the OTA 408. In an embodiment, the resistors R212 and R213 may have the same resistance value. The capacitors C212 and C213 may have the same capacitance value.

The positive and negative input, respectively, of the OTA 406 is connected to the positive and negative input, respectively, of OTA 408 to provide a positive and negative input terminal, respectively, for receiving an input current 422. Capacitor C210 has its positive terminal connected to the negative terminal of capacitor C212 to provide a positive output terminal. Similarly, capacitor C211 has its positive terminal connected to the negative terminal of capacitor C213 to provide a negative output terminal. The positive and negative output terminals provide an output voltage 424.

An offset-current source I21 is connected to both the negative output of OTA 406 and the negative terminal of capacitor C210. An offset-current source I22 is connected to both the positive output of OTA 406 and the negative terminal of capacitor C211. An offset-current source I23 is connected to both the negative output of OTA 408 and the positive terminal of capacitor C212. An offset-current source I24 is connected to both the positive output of OTA 408 and the positive terminal of capacitor C213.

The offset-current source I21 provides an offset-current to both the negative output of OTA 406 and the negative terminal of capacitor C210. The offset-current source I22 provides an offset-current to both the positive output of OTA 406 and the negative terminal of capacitor C211.

The offset-current source I23 provides an offset-current to both the negative output of OTA 408 and the positive terminal of capacitor C212. The offset-current source I24 provides an offset-current to both the positive output of OTA 408 and the positive terminal of capacitor C213.

Together with the feedback loops of R210 and R211, respectively, of OTA 406 the off-set current sources I21 and I22 provide a proper DC offset voltage of about 0.5V (or higher) for capacitors C210 and C211, respectively. Together with the feedback loops of R212 and R213, respectively, of OTA 408 the off-set current sources I23 and I24 provide a proper DC offset voltage of about 0.5V (or higher) for capacitors C212 and C213, respectively.

In the arrangement of figure 7b, the capacitors C210 en C212 are arranged in an anti-parallel circuit, where current sources I21 and I23 cause an offset voltage in order to produce a semi-ideal MOS capacitor circuit, like the one shown on top of the ellipse in figure 8. So, the circuit elements comprising capacitor C210, resistor R210, and current source I21 arranged in parallel to the circuit elements comprising capacitor C212, resistor R212, and current source 123 together form an implementation of the capacitor C200 of figure 7a, with linear capacitance-voltage characteristic.

In a similar way, the capacitors C211 en C213 are arranged in an anti-parallel circuit, where current sources I22 and I24 cause an offset voltage in order to produce a semi-ideal MOS capacitor circuit, like the one shown on top of the ellipse in figure 8. So, the circuit elements comprising capacitor C211, resistor R211, and current source I22 arranged in parallel to the circuit elements comprising capacitor C213, resistor R213, and current source 124 together form an implementation of the capacitor C201 of figure 7a, with linear capacitance-voltage characteristic.

The resistors R210, R211, R212, R213 may have the same resistance value. The capacitors C210, C211, C212 and C213 may have the same capacitance value. In an embodiment, the offset-current source I21 provides, substantially, the same offset-current as offset-current source I24. In an embodiment, the offset-current source I22 provides, substantially, the same offset-current as offset-current source I23. The offset-current provided by I21 added to the offset-current provided by I23, preferably, equals zero. The offset-current provided by I22 added to the offset-current provided by I24, preferably, equals zero.

OTA 406 is, preferably, arranged in the same way as OTA 408.

There are twice as many capacitors in circuit arrangements 202, 302, and 402, respectively, in figures 5b, 6b and 7b, respectively, than the number of capacitors in circuit arrangements 200, 300, and 400, respectively, in figures 5a, 6a and 7a, respectively. However, the capacitors in the arrangements of figures 5b, 6b, and 7b, respectively, may be designed such as to have half the size of the capacitors in the arrangements of figures 5a, 6a, and 7a, respectively. The total capacitor area is therefore not increased in the proposed circuits of figures 5b, 6b, and 7b. The only penalty for the linear capacitors is extra circuits, i.e. an extra OTA, additional offset-current sources and extra resistors. In a lot of low noise applications, the capacitors will dominate the total area needed on the chip accommodating the circuit, making it attractive to use the proposed circuits when linearity of the capacitors is the dominant performance requirement.

It is to be understood that the invention is limited by the annexed claims and its technical equivalents only. In this document and in its claims, the verb "to comprise" and its conjugations are used in their non-limiting sense to mean that items following the word are included, without excluding items not specifically mentioned. In addition, reference to an element by the indefinite article "a" or "an" does not exclude the possibility that more than one of the element is present, unless the context clearly requires that there be one and only one of the elements. The indefinite article "a" or "an" thus usually means "at least one".

### References

[1] T. Tille, J. Sauerbrey, M. Mauthe, and D. Schmitt-Landsiedel, "Design of Low-Voltage MOSFET-Only ∑Δ Modulators in Standard Digital CMOS Technology" IEEE Trans. On Circuits and Systems I, vol. 51, January 2004, pp. 96 - 109
[2] H. Yoshizawa, Y. Huang, P. Ferguson, and G. Temes "MOSFET-Only Switched-Capacitor Circuits in Digital CMOS Technology," IEEE J. Solid-State Circuits, vol. 34, June 1999, pp. 734 - 746
[3] M. Danaie, H. Aminzadeh, and S. Naseh, "On the Linearization of MOSFET Capacitors," in Proc. ISCAS2007, 2007, pp 1943 - 1946
[4] K. Rajkanan, and B. Kranzen, "MOS Precision Capacitor with Low Voltage Coefficient," U.S. Patent 5608258, March 4, 1997
[5] A. Ghilardelli, S. Ghezzi, and C. Golla, "MOS Capacitor with Wide Voltage and Frequency Operating Ranges," U.S. Patent 6590247 B2, July 8, 2003

## Claims

1. A MOS capacitor structure comprising:
• a first series connection of a first offset-voltage source and a first MOS capacitor, said first offset-voltage source providing a first offset voltage to said first MOS capacitor;
• a second series connection of a second offset-voltage source and a second MOS capacitor, said second offset-voltage source providing a second offset voltage to said second MOS capacitor;
said first and second series connections being connected in parallel such that said first and second MOS capacitors are arranged in an anti-parallel way, and such as to provide a first input terminal and a first output terminal.

2. MOS capacitor structure according to claim 1, wherein said first and second MOS capacitors have a same capacitance value.

3. MOS capacitor structure according to claim 1 or 2, wherein
said first offset-voltage source comprises a first resistor and a first current source, the first resistor at one side being connected to one side of the first MOS capacitor at a first connection point, said first current source also being connected to said first connection point,
said second offset-voltage source comprises a second resistor and a second current source, the second resistor at one side being connected to one side of the second MOS capacitor at a second connection point, said second current source also being connected to said second connection point.

4. MOS capacitor structure according to claim 1, 2 or 3 comprising:
• a third series connection of a third offset-voltage source and a third MOS capacitor, said third offset-voltage source providing a third offset voltage to said third MOS capacitor;
• a fourth series connection of a fourth offset-voltage source and a fourth MOS capacitor, said fourth offset-voltage source providing a fourth offset voltage to said fourth MOS capacitor;
said third and fourth series connections being connected in parallel such that said third and fourth MOS capacitors are arranged in an anti-parallel way, and such as to provide a second input terminal and a second output terminal, allowing an input voltage to be supplied between the first and second input terminals, and an output voltage to be output between the first and second output terminals.

5. MOS capacitor structure according to claim 4, wherein said third and fourth MOS capacitors have a same capacitance value.

6. MOS capacitor structure according to claim 5 or claim 4 in its dependency on claim 3 wherein
said third offset-voltage source comprises a third resistor and a third current source, the third resistor at one side being connected to one side of the third MOS capacitor at a third connection point, said third current source also being connected to said third connection point,
said fourth offset-voltage source comprises a fourth resistor and a fourth current source, the fourth resistor at one side being connected to one side of the fourth MOS capacitor at a fourth connection point, said fourth current source also being connected to said fourth connection point.

7. MOS capacitor structure according to claim 6, wherein said first, second, third and fourth resistors have a same resistance value.

8. MOS capacitor structure according to any of the claims 6-7, wherein a first offset-current provided by the first offset-current source added to a third offset-current provided by the third offset-current source equals zero, a second offset-current provided by the second offset-current source added to a fourth offset-current provided by the fourth offset-current source equals zero.

9. MOS capacitor structure according to any of the claims 6-8 comprising:
• a first operational amplifier having a first positive input, a first negative input, a first positive output and a first negative output,
• a second operational amplifier having a second positive input, a second negative input, a second positive output and a second negative output,
said first resistor at another side being connected to said first positive input, said first negative output being connected to said first connection point,
said second resistor at another side being connected to said second positive input,
said second negative output being connected to said second connection point, said third resistor at another side being connected to said first negative input, said first positive output being connected to said third connection point,
said fourth resistor at another side being connected to said second negative input,
said second positive output being connected to said fourth connection point.

10. MOS capacitor structure according to claim 9, wherein said first MOS capacitor has another side connected to said second positive input, said second MOS capacitor has another side connected to said second positive input, said third MOS capacitor has another side connected to said first negative input, and said fourth MOS capacitor has another side connected to said second negative input.

11. MOS capacitor structure according to claim 10, wherein said MOS capacitor structure comprises:
• a fifth MOS capacitor having one side connected to said first connection point and another side connected to a first output terminal, and a sixth MOS capacitor having one side connected to said second connection point and another side connected to said first output terminal, the fifth and sixth MOS capacitors being connected in an anti-parallel fashion
• a seventh MOS capacitor having one side connected to said third connection point and another side connected to a second output terminal, and an eighth MOS capacitor having one side connected to said fourth connection point and another side connected to said second output terminal, the seventh and eighth MOS capacitors being connected in an anti-parallel fashion.

12. MOS capacitor structure according to claim 9, wherein said first MOS capacitor has another side connected to a first output terminal, and said second MOS capacitor has another side connected to said first output terminal, said third MOS capacitor has another side connected to a second output terminal, and said fourth MOS capacitor has another side connected to said second output terminal.
